# EUROPEAN PATENT APPLICATION

(11) **EP 4 697 376 A1**
(43) Date of publication of application: **18.02.2026**
(21) Application number: 24819077.9
(22) Date of filing: 09.05.2024
(51) Int. Cl.: H01L 21/304, H01L 21/027, H01L 21/306

(54) **SUBSTRATE PROCESSING APPARATUS**

(30) Priority: 08.06.2023 JP 2023094879
(71) Applicant: J.E.T. Co., Ltd., Okayama 719-0302 (JP)
(72) Inventor: BONO, Masayuki, Asakuchi-gun, Okayama 719-0302 (JP)
(74) Representative: Bandpay & Greuter
(86) International application number: PCT/JP2024/017241
(87) International publication number: WO 2024/252840

(57) **Abstract**

A substrate processing device capable of heating a substrate in an aspect suitable for accurate temperature measurement is provided. A heating unit 18 heats a substrate 11 by irradiating the substrate 11 with light from an LED of a light source unit 34. The LED outputs light of a single wavelength having a peak wavelength in a wavelength range that is not transmitted through the substrate 11. A radiation thermometer provided in an LED unit 37 measures a temperature of the substrate 11 by detecting light in a wavelength range that does not include the wavelength of the light output by the LED. A light emission control unit 35 increases or decreases the intensity of light output by each LED based on the temperature of the substrate 11 measured by the radiation thermometer.

## Description

### Technical Field

The present invention relates to a substrate processing device.

### Background Art

In general, in a semiconductor device manufacturing process, a resist film, which is photosensitive resin, is commonly used as a mask for etching, ion implantation, or the like to form a circuit pattern on a substrate. For example, after etching, ion implantation, or the like is performed using the resist film formed on a processing surface of a silicon substrate (silicon wafer) as a mask, the resist film is removed from the processing surface of the silicon substrate. SPM cleaning is known as a method for removing the resist film. In the SPM cleaning, the silicon substrate is immersed in sulfuric acid-hydrogen peroxide mixture obtained by mixing sulfuric acid and hydrogen peroxide solution, thereby dissolving and removing the resist film by persulfuric acid (Caro's acid, peroxomonosulfuric acid) generated by the sulfuric acid-hydrogen peroxide mixture. The generation of the persulfuric acid is usually promoted by heating the sulfuric acid-hydrogen peroxide mixture to 100°C or higher.

A substrate processing device (for example, refer to PTL 1) is known in which a silicon substrate held on a rotating table is irradiated by infrared light from an infrared lamp and sulfuric acid-hydrogen peroxide mixture is sprayed onto a processing surface of the silicon substrate while the silicon substrate is heated, thereby removing a resist film. The infrared lamp may be, for example, a tungsten lamp. A temperature of the silicon substrate during heating is measured using a radiation thermometer.

### Citation List

### Patent Literature

PTL 1: WO2011/074521

### Summary of Invention

### Technical Problem

Incidentally, light emitted from an infrared lamp has a wide range of wavelengths, including near-infrared (wavelengths in a range of approximately 0.7 µm to 2.5 µm), mid-infrared (wavelengths in a range of approximately 2.5 µm to 4 µm), and far-infrared (wavelengths of approximately 4 µm or more). Meanwhile, a radiation thermometer obtains a temperature of a substrate by detecting light in a wavelength range of near-infrared to far-infrared emitted from the substrate such as a silicon substrate. Therefore, there is a problem that if part of the light emitted from the infrared lamp is reflected inside a substrate processing device and enters the radiation thermometer as disturbance light, an error occurs in the measured temperature of the substrate.

The present invention has been made in view of the above circumstances, and an object thereof is to provide a substrate processing device capable of heating a substrate in an aspect suitable for accurate temperature measurement.

### Solution to Problem

A substrate processing device of the present invention includes: a rotating table rotatably disposed around a vertical axis and configured to rotate during processing for a processing surface of a substrate; a substrate holding unit provided on the rotating table and configured to hold the substrate horizontally with the processing surface facing downward and being away from an upper surface of the rotating table, and to rotate integrally with the rotating table; a process liquid supply unit disposed between the substrate held on the rotating table and the rotating table, and configured to spray a fluid for processing to supply the fluid for processing to the processing surface; and a heating unit disposed above the substrate held on the rotating table, including a plurality of light emitting diodes that emit light onto the substrate while the fluid for processing is being supplied to the processing surface, and configured to heat the substrate with the light from the plurality of light emitting diodes.

### Advantageous Effects of Invention

According to the present invention, since the light emitting diode is used as a light source for heating the substrate, the temperature of the substrate can be measured by detecting light in a wavelength range that does not include the wavelength of the light output by the light emitting diode, and the temperature of the substrate can be accurately measured without being affected by the light from the light emitting diode.

### Brief Description of Drawings

Fig. 1 is a cross-sectional view illustrating a configuration of a substrate processing device.
Fig. 2 is an illustrative diagram illustrating an example of arrangement of light emitting diodes and radiation thermometers in a heating unit.
Fig. 3 is a graph illustrating a spectral transmittance of a silicon substrate.
Fig. 4 is an illustrative diagram illustrating another example of the arrangement of the light emitting diodes and the radiation thermometers in the heating unit.

### Description of Embodiments

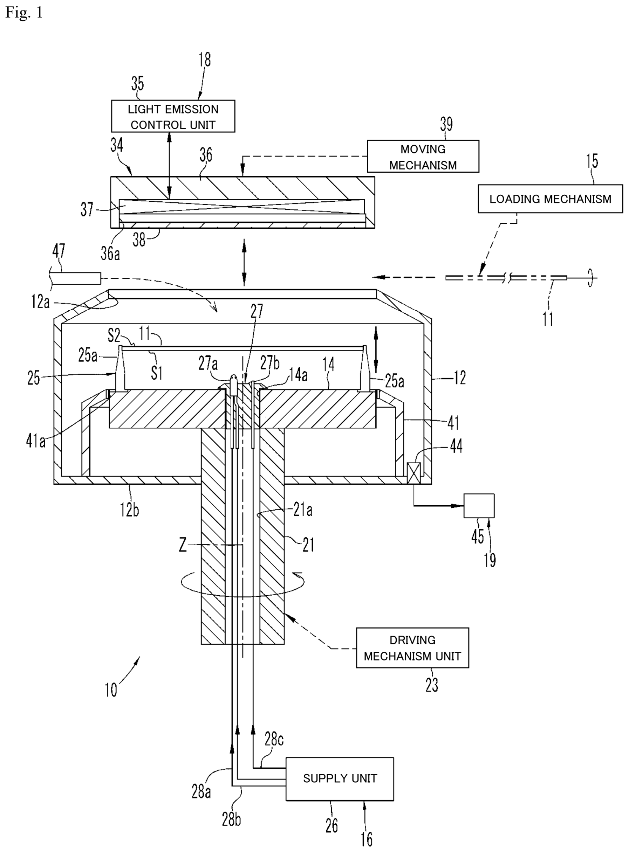

In Fig. 1, a substrate processing device 10 removes a resist (photoresist, photosensitive resin) film (not illustrated) formed on a substrate 11. In this example, the substrate processing device 10 removes the resist film using a sulfuric acid-hydrogen peroxide mixture obtained by mixing sulfuric acid and a hydrogen peroxide solution. In this example, the substrate 11 is a single-crystal silicon substrate (silicon wafer). One surface of the substrate 11 is a processing surface S1, which is an object to be processed. That is, the processing surface S1 is a substrate surface (a surface of the silicon wafer) on which a circuit including a semiconductor element and the like is formed, and the substrate processing device 10 removes the resist film formed when forming the circuit on this processing surface S1. The substrate 11 is not limited to the silicon substrate, but may be various other substrates, such as a compound semiconductor substrate (for example, a III-V semiconductor substrate such as an InP or GaAs substrate) or a SiC substrate.

The substrate processing device 10 includes a housing 12, a rotating table 14, a loading mechanism 15, a process liquid supply unit 16, a heating unit 18, and a discharge unit 19, and the units are centrally controlled by a control unit (not illustrated). The housing 12 has a bottomed cylindrical shape, and has a circular upper opening 12a opened at an upper portion. The upper opening 12a is formed to have a larger diameter than that of the substrate 11. The substrate 11 is placed in and removed from the housing 12 through this upper opening 12a. As described below, in this example, the upper opening 12a serves as an inlet for introducing outside air into the housing 12.

The rotating table 14 is a disk shape, and is disposed in the housing 12. The substrate 11 is accommodated in the housing 12. The rotating table 14 is fixed to an upper end portion of a driving shaft 21. The driving shaft 21 is coaxial with the rotating table 14. The driving shaft 21 penetrates a bottom surface 12b of the housing 12 in a thickness direction (upper-lower direction) of the bottom surface 12b. A through-hole 21a penetrating in the upper-lower direction is formed inside the driving shaft 21, and a through-hole 14a connected to the through-hole 21a is formed in a center portion of the rotating table 14.

The rotating table 14 is rotated and moved in the upper-lower direction by a driving mechanism unit 23. The rotating table 14 is configured to rotate integrally with the driving shaft 21 around a vertical rotation axis (vertical axis) Z, and rotates with an upper surface horizontal. The rotating table 14 is also configured to move integrally with the driving shaft 21 in the upper-lower direction, and moves between a raised position where an upper portion of a substrate holding unit 25 to be described later protrudes from the upper opening 12a and a lowered position where the rotating table 14 moves downward from this raised position and receives the substrate 11 in the housing 12 for processing. When transmitting and receiving the substrate 11 between the loading mechanism 15 and the substrate holding unit 25, the rotating table 14 is at the raised position.

The driving mechanism unit 23 includes a motor, which serves as a power source for rotating and moving the driving shaft 21 in the upper-lower direction, and a gear that uses a driving force of the motor to rotate and move the driving shaft 21 in the upper-lower direction. The driving mechanism unit 23 rotates the rotating table 14 by rotating the driving shaft 21, and moves the rotating table 14 between the raised position and the lowered position by moving the driving shaft 21 in the upper-lower direction. A rotation speed of the rotating table 14 is adjusted by increasing or decreasing a speed of a motor of the driving mechanism unit 23.

The substrate holding unit 25 that holds the substrate 11 is provided on the upper surface of the rotating table 14. The substrate holding unit 25 includes a plurality of chuck pins 25a provided on a peripheral edge portion of the rotating table 14 and a plurality of support pins (not illustrated) provided adjacent to the chuck pins 25a, and these chuck pins 25a and support pins rotate integrally with the rotating table 14. The plurality of chuck pins 25a and support pins are arranged at predetermined intervals in a circumferential direction of the rotating table 14. In Fig. 1, only two chuck pins 25a are illustrated, but in reality, for example, six chuck pins 25a and six support pins are provided.

The support pins of the substrate holding unit 25 are adjusted such that the support pins are all at the same height from the upper surface of the rotating table 14. When holding the substrate 11 on the rotating table 14, the loading mechanism 15 places a peripheral edge portion of the substrate 11 on upper ends of the support pins, and in this state, the chuck pins 25a respectively move toward the center of the rotating table 14. Accordingly, the chuck pins 25a clamp the substrate 11 and hold the substrate 11 parallel, that is, horizontally, at a predetermined interval from the upper surface of the rotating table 14. In this way, the substrate 11 is held by the substrate holding unit 25 and fixed coaxially with the rotating table 14. The fixed substrate 11 rotates integrally with the rotating table 14. When the substrate 11 is to be transferred to the loading mechanism 15, the chuck pins 25a respectively move toward an outer periphery of the rotating table 14, and release the holding on the substrate 11. Note that the above configuration of the substrate holding unit 25 is an example, and is not limited thereto.

As described above, the loading mechanism 15 transmits and receives the substrate 11 to and from the substrate holding unit 25. The loading mechanism 15 is implemented by a plurality of carrier arms, a substrate inverting unit, and the like. The substrate 11 is stored in a storage cassette (not illustrated) with the processing surface S1 facing upward. The substrate 11, which is an object to be processed, is taken out from the storage cassette by the carrier arms and carried to the substrate inverting unit, and then is inverted by the substrate inverting unit such that the processing surface S1 faces downward, and then is moved by another carrier arm from the substrate inverting unit to a position supported by the substrate holding unit 25. Therefore, in this example, the loading mechanism 15 is a setting mechanism that sets the substrate 11 on the substrate holding unit 25 with the processing surface S1 facing downward.

The process liquid supply unit 16 supplies, as process liquids, a sulfuric acid-hydrogen peroxide mixture for removing a resist film formed on the processing surface S1 and pure water for cleaning (pure water rinsing) the processing surface S1 to the processing surface S1. The process liquid supply unit 16 includes a supply unit 26, a nozzle unit 27, and supply pipes 28a to 28c. The nozzle unit 27 includes a nozzle head 27a that sprays the sulfuric acid-hydrogen peroxide mixture and a nozzle head 27b that sprays the pure water, and is disposed in the through-hole 14a of the rotating table 14. That is, the nozzle heads 27a and 27b are disposed at the center portion of the rotating table 14 and are exposed from an upper side of the rotating table 14. The nozzle unit 27 moves integrally with the rotating table 14, but is fixed and separated from the rotating table 14 in a rotation direction.

In this example, the nozzle head 27a is, for example, a dome shape in which a plurality of nozzle holes is formed, and mixes the sulfuric acid-hydrogen peroxide mixture to be supplied with nitrogen (N₂) gas in the hollow interior and sprays the mixture toward the processing surface S1 through the nozzle holes. The nozzle head 27b includes a plurality of nozzles that spray pure water to be supplied, and the pure water is sprayed from the nozzles toward the processing surface S1. The nozzle heads 27a and 27b are adjusted in terms of a spray direction, a spray amount, and the like to uniformly supply the sulfuric acid-hydrogen peroxide mixture and the pure water to the substrate 11 which rotates together with the rotating table 14.

The supply pipes 28a to 28c each pass through the through-hole 21a of the driving shaft 21, and one end of each is connected to the nozzle unit 27. The other end of each of the supply pipes 28a to 28c is connected to the supply unit 26. This supply unit 26 supplies, to the nozzle head 27a, the sulfuric acid-hydrogen peroxide mixture through the supply pipe 28a and the nitrogen gas through the supply pipe 28b, and supplies the pure water to the nozzle head 27b through the supply pipe 28c. The supply of the sulfuric acid-hydrogen peroxide mixture and the nitrogen gas and the supply of the pure water are selectively performed, and the pure water is supplied after the resist film is removed by the sulfuric acid-hydrogen peroxide mixture. In this example, the sulfuric acid-hydrogen peroxide mixture is a fluid for processing.

The heating unit 18 heats the substrate 11 by irradiating the substrate 11 with light, and includes a light source unit 34 disposed above the housing 12, and a light emission control unit 35. The light source unit 34 includes a housing 36, an LED unit 37 accommodated in a bottom opening 36a of the housing 36, and a transparent protective plate 38 that covers the bottom opening 36a.

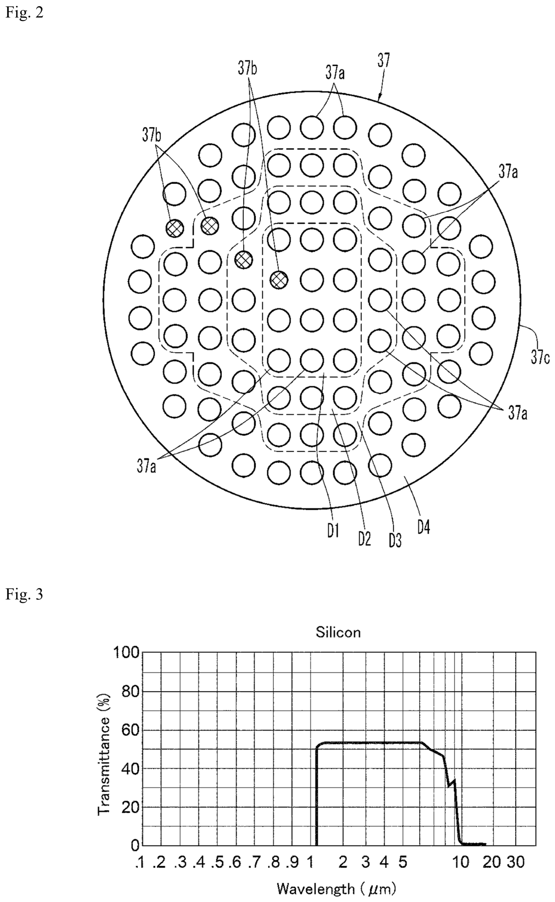

The LED unit 37 includes a plurality of LEDs (light emitting diodes) 37a (refer to Fig. 2), and emits light from the LEDs 37a downward through the protective plate 38. The light emission control unit 35 increases or decreases the intensity of the light output by the LEDs 37a based on a temperature of the substrate 11 measured by radiation thermometers 37b (refer to Fig. 2) provided in the LED unit 37. Accordingly, the substrate 11 is maintained at a desired temperature.

The light source unit 34 is disposed directly above the upper opening 12a and is moved in the upper-lower direction by a moving mechanism 39 between a heating position where the light source unit 34 comes close to the upper opening 12a to heat the substrate 11, and a retracted position where the light source unit 34 moves upward from the heating position to allow the substrate 11 to enter and be removed from the upper opening 12a. The light source unit 34 at the heating position forms a small gap with a peripheral edge of the upper opening 12a. In this example, the light source unit 34 is moved in the upper-lower direction to the heating position and the retracted position, and the light source unit 34 may also be moved in a horizontal direction with the retracted position being a position reached horizontally from a position directly above the upper opening 12a so as not to interfere with the entering and removal of the substrate 11.

When the resist film is removed from the substrate 11, the light source unit 34 is at the heating position. At this heating position, the light source unit 34 emits light from the LEDs 37a through the upper opening 12a to the back surface S2 of the substrate 11 (a surface opposite the processing surface S1, a back surface of the silicon wafer) directly below the light source unit 34, thereby heating the substrate 11. By heating the substrate 11, oxidative decomposition of the resist film using the sulfuric acid-hydrogen peroxide mixture is promoted.

A guide cylinder 41 is provided in the housing 12. The guide cylinder 41 in this example has a cylindrical shape in which an upper portion of the guide cylinder 41 is made in a tapered shape with a diameter thereof gradually decreasing upward. The guide cylinder 41 is fixed to the housing 12, for example, and an axial center of the guide cylinder 41 is adjusted to coincide with a rotation center of the rotating table 14. A lower end of the guide cylinder 41 reaches the bottom surface 12b of the housing 12. The rotating table 14 at the lowered position is placed in an opening 41a at an upper portion of the guide cylinder 41. An inner diameter of the opening 41a is slightly larger than an outer diameter of the rotating table 14, and a gap between the rotating table 14 and the guide cylinder 41 is narrowed. The guide cylinder 41 forms an exhaust route between the guide cylinder 41 and the housing 12. By providing the guide cylinder 41, particles are prevented from being stirred up due to the rotation of the rotating table 14, adhesion of the particles to the substrate 11 is reduced, and a process liquid and vapors thereof are prevented from flowing into mechanical units such as the driving shaft 21.

The discharge unit 19 includes the upper opening 12a as the inlet described above, a discharge port 44 formed on the bottom surface 12b of the housing 12, a suction device 45, and the like. The suction device 45 uses, for example, a pump and is connected to the discharge port 44. The discharge unit 19 drives the suction device 45 to perform suction through the discharge port 44, thereby generating a pressure difference that makes a pressure at the discharge port 44 lower than a pressure between the substrate 11 and the rotating table 14 and a pressure at the upper opening 12a. Accordingly, an airflow passing between the housing 12 and the guide cylinder 41 from the upper opening 12a toward the discharge port 44 is formed, various gases, process liquids and droplets thereof, and foreign matters such as particles generated during processing that flow out from a position between the substrate 11 and the rotating table 14 are efficiently guided to the discharge port 44 to be discharged to the outside of the housing 12, and are prevented from leaking to the outside of the housing 12 from the upper opening 12a. The discharge port 44 is provided with a gas-liquid separation mechanism, and a gas and a liquid are separated and discharged. Note that mist in the gas discharged from the discharge port 44 and vaporized gas generated from the process liquid are collected by a demister or the like.

A water pipe 47 is provided outside the housing 12 and near the upper opening 12a. The water pipe 47 supplies pure water discharged from a tip end to the back surface S2 of the substrate 11 held on the rotating table 14 inside the housing 12 to clean the back surface S2.

In Fig. 2, the plurality of LEDs 37a are arranged at the LED unit 37. In the LED unit 37, the plurality of LEDs 37a are distributed and arranged on a circular base plate 37c that faces the substrate 11, that is, directly above the substrate 11 and has approximately the same size as that of the substrate 11. That is, the plurality of LEDs 37a are distributed and arranged in a facing region that has approximately the same size as that of the substrate 11. Accordingly, the substrate 11 is heated uniformly. The number of LEDs 37a is not limited.

In this example, the base plate 37c is divided into four regions D1 to D4 from a center of the base plate 37c toward the outside, and the plurality of LEDs 37a are divided into four groups corresponding to these regions D1 to D4 and controlled by the light emission control unit 35. That is, the LEDs 37a arranged in the region D1 at a center portion of the base plate 37c, the LEDs 37a arranged in the region D2 outside the region D1, the LEDs 37a arranged in the region D3 outside the region D2, and the LEDs 37a arranged in the region D4 at the outermost periphery are separately controlled. Each of the regions D1 to D4 is provided with one radiation thermometer 37b. The radiation thermometers 37b are positioned offset from each other in a radial direction of the base plate 37c. Therefore, in a state where the light source unit 34 is at the heating position and the LED unit 37 faces the substrate 11, the radiation thermometers 37b are positioned to face different positions in the radial direction of the substrate 11.

In this example, the temperature measurement unit is implemented by four radiation thermometers 37b. The number of radiation thermometers 37b constituting the temperature measurement unit may be one or more, and can be determined freely depending on a control mode.

Based on a temperature measurement result of the substrate 11 obtained by one radiation thermometer 37b, the light emission control unit 35 adjusts the intensity of the light output by the LEDs 37a arranged in the same region as the radiation thermometer 37b. Accordingly, heating is controlled such that a target temperature is uniformly maintained from the center portion to the outer peripheral portion of the substrate 11.

By using the LEDs 37a as the light source for heating the substrate 11, the life of the light source unit 34 is longer than that of an infrared lamp such as a tungsten lamp. As a result, a frequency of maintenance of the light source unit 34 can be reduced, an operating rate of the device is improved. The light output by the LEDs 37a does not have a wide wavelength range like that of the infrared lamp, but has a limited wavelength range. Therefore, it is easy to configure the radiation thermometer 37b to detect light having a wavelength or wavelength range different from that of the light from the LEDs 37a, that is, to measure the temperature of the substrate 11 by preventing the radiation thermometer 37b from receiving the light from the LEDs 37a. Accordingly, the temperature of the substrate 11 can be accurately measured without being affected by the light from the LEDs 37a.

It is preferable that the LEDs 37a output light of a single wavelength, and preferably light in a wavelength range that is not transmitted through the substrate 11. The light of a single wavelength output by the LEDs 37a does not need to have a strictly single wavelength, and as a single wavelength in general, the light may have a certain spread around a single wavelength (peak wavelength). Note that light includes visible light as well as electromagnetic waves such as infrared, which has a longer wavelength than that of visible light, and ultraviolet, which has a shorter wavelength than that of visible light.

By using the LEDs 37a that output the light of a single wavelength, it is possible to more easily measure the temperature of the substrate 11 by preventing the radiation thermometer 37b from receiving light from the LEDs 37a. By using the LEDs 37a that output the light in the wavelength range that is not transmitted through the substrate 11, it is possible to prevent the light from the LEDs 37a from transmitting through the substrate 11 to heat, deteriorate, or deform the rotating table 14 or the like, and by preventing heating the rotating table 14, the temperature measurement by the radiation thermometer 37b is not affected by the heat of the rotating table 14, and the temperature of the substrate 11 can be more accurately measured. The wavelength range that is not transmitted through the substrate 11 may be any wavelength range where a transmittance is relatively low or regarded to be sufficiently low relatively based on transmission characteristics (spectral transmittance) of the substrate 11, and is preferably a wavelength range where the transmittance is "0" or regarded as "0".

In this example, the substrate 11, that is, a single-crystal silicon wafer, has a high transmittance for light (infrared) with a wavelength of 1.1 µm or more, as illustrated in a spectral transmittance in Fig. 3. Therefore, it is preferable to use one that outputs light of less than 1.1 µm for the substrate 11 (silicon wafer) as the LED 37a. Accordingly, the light from the LED 37a is prevented from transmitting through the substrate 11, thereby preventing heating, deterioration, deformation, and the like of the rotating table 14 or the like. By preventing the rotating table 14 or the like from being heated, the temperature of the substrate 11 can be more accurately measured. Note that the substrate 11 (silicon wafer) transmits light having wavelengths starting from approximately 1 µm, and the transmittance nearly saturates at 1.1 µm of the wavelength, and thus, it is preferable to use one that outputs light with a wavelength of 1 µm or less as the LED 37a.

The LED 37a may use one in which light to be output spreads over a predetermined wavelength range, such as a blue LED, that is, a white diode having a structure that combines an active layer generating blue light with a yellow phosphor. In this case, it is preferable that the entire wavelength range of the light output by the LED 37a falls within the wavelength range that is not transmitted through the substrate 11. It is particularly preferable that in the LEDs 37a that output the light of a single wavelength with a peak wavelength within the wavelength range that is not transmitted through the substrate 11, the peak wavelength and surrounding wavelengths further preferably fall within the wavelength range that is not transmitted through the substrate 11. Furthermore, the LED 37a may output the light of the wavelength or wavelength range as described above by using an optical filter that selectively transmits or reflects specific wavelengths or wavelength ranges, such as a high-pass filter, a low-pass filter, or a band-pass filter.

In order to achieve high external quantum efficiency and efficient heating of the substrate 11, the peak wavelength of the light output by the LED 37a is preferably in a range of 0.35 µm or more and 0.70 µm or less, more preferably in a range of 0.37 µm or more and 0.65 µm or less, and further preferably in a range of 0.40 µm or more and 0.50 µm or less or 0.60 µm or more and 0.65 µm or less. For similar reasons, the active layer of the LED 37a is preferably implemented by an AlGaInP-based semiconductor or a III-V nitride compound semiconductor in which the Group V element is N (nitrogen), such as a GaN-based, AlGaN-based, InGaN-based, or AlInGaN-based semiconductor.

In this example, the LED 37a may use one that outputs light of a single wavelength with a peak wavelength in the wavelength range that is not transmitted through the substrate 11 (light of a single wavelength in which the wavelength range of light to be output is included in the wavelength range that is not transmitted through the substrate 11). More specifically, in this example, the LED 37a outputs the light of a single wavelength with a peak wavelength in a range of 0.40 µm or more and 0.50 µm or less.

The radiation thermometer 37b measures the temperature of the substrate 11 by measuring the intensity of the light emitted from the substrate 11. This radiation thermometer 37b receives (detects) the light in a wavelength range that does not include the wavelength of the light output by LED 37a. Accordingly, the temperature of the substrate 11 is accurately measured without being affected by the light output by the LED 37a. That is, even if the light from the LED 37a enters the radiation thermometer 37b as ambient light, the radiation thermometer 37b accurately measures the temperature of the substrate 11 without being affected by that light.

A structure of the radiation thermometer 37b or the like is not limited. The radiation thermometer 37b may use, for example, a monochromatic radiation thermometer that obtains a temperature from light (infrared) of a single wavelength (narrow wavelength range) and an emissivity, a partial radiation thermometer that obtains a temperature from light of a relatively wide wavelength range and an emissivity, and a two-color radiation thermometer that obtains a temperature from a ratio of radiances by using two measurement wavelengths. The radiation thermometer 37b may have a structure in which an optical filter such as a high-pass filter, a low-pass filter, or a band-pass filter is provided in front of a light receiving element (light receiving surface) of the radiation thermometer 37b to block the light output by the LED 37a and transmit the light for the radiation thermometer 37b to measure the temperature. Note that even if the radiation thermometer 37b is not sensitive according to a specification, the radiation thermometer 37b may be slightly sensitive to the light from the LED 37a, and thus, providing the radiation thermometer 37b with an optical filter that blocks the light from the LED 37a is useful for accurately measuring the temperature of the substrate 11.

As described above, the heating unit 18 heats the substrate 11 with the light from the LED 37a, and since the wavelength range of this light is limited, it is easy to configure the radiation thermometer 37b to measure the temperature of the substrate 11 with the light in the wavelength range that does not include the light from the LED 37a, which is made even easier by using a LED 37a of a single wavelength.

Next, effects of the above configuration will be described. Note that a processing procedure described below is an example and is not intended for the limitation. The suction device 45 is constantly driven, and the interior of the housing 12 is in a suctioned state. The light source unit 34 is moved to the retracted position. The rotating table 14 is moved to the raised position, and the tip ends of the support pins of the substrate holding unit 25 protrude upward from the upper opening 12a of the housing 12. In this state, the loading mechanism 15 places, on the support pins, the peripheral edge portion of the substrate 11 with the processing surface S1 facing downward. After the holding of the substrate 11 by the loading mechanism 15 is released, the substrate 11 is clamped by the chuck pins 25a. Accordingly, the substrate 11 is fixed on the rotating table 14 with the processing surface S1 facing downward.

After the substrate 11 is fixed, the rotating table 14 is moved to the lowered position, and the substrate 11 rotates integrally with the rotating table 14 by the driving mechanism unit 23. After the rotating table 14 begins to rotate, the light source unit 34 is moved to the heating position. The supply unit 26 begins to supply the sulfuric acid-hydrogen peroxide mixture, and the light emission control unit 35 turns on the LEDs 37a of the light source unit 34. By turning on the LEDs 37a, the substrate 11 is heated from the back surface S2 to a predetermined temperature (for example, 240°C).

As described above, the substrate 11 is held with the processing surface S1 facing downward, and the light from the LEDs 37a is incident on the back surface S2 where no circuit pattern is formed. Therefore, unlike a case of a configuration in which the substrate 11 is held with the processing surface S1 facing upward and the light is incident on the processing surface S1, reflection and scattering due to wiring or the resist film of the circuit pattern formed on the processing surface S1, unevenness of an insulating film, tapered surfaces of the wiring or the insulating film, and the like do not occur. Therefore, in the substrate processing device 10, the substrate 11 is uniformly and efficiently heated by the light from the LEDs 37a without being affected by the reflection or scattering due to the circuit pattern. The substrate 11 is heated from the back surface S2, and thus, heat diffuses in the substrate 11 and is transferred to the processing surface S1. Accordingly, the processing surface S1 is heated by a more uniform temperature.

The sulfuric acid-hydrogen peroxide mixture from the supply unit 26 is supplied to the nozzle head 27a through the supply pipe 28a together with nitrogen gas from the supply pipe 28b. Accordingly, the sulfuric acid-hydrogen peroxide mixture is sprayed together with nitrogen gas from nozzle holes of the nozzle head 27a toward the processing surface S1 of the substrate 11. The sulfuric acid-hydrogen peroxide mixture supplied to the processing surface S1 from the nozzle head 27a flows across the processing surface S1 toward the outer periphery of the substrate 11 while spreading in the circumferential direction due to the rotation of the substrate 11. Accordingly, the entire surface of the processing surface S1 is exposed to the sulfuric acid-hydrogen peroxide mixture sprayed from the nozzle head 27a. When the resist film of the processing surface S1 is exposed to the sulfuric acid-hydrogen peroxide mixture in this manner, the exposed portion is oxidatively decomposed by the sulfuric acid-hydrogen peroxide mixture, and is gradually decomposed and removed. The processing surface S1 faces downward, and thus foreign matters such as particles generated on the processing surface S1 are less likely to remain on the processing surface S1. The particles and the like that separate from the processing surface S1 fall onto the rotating table 14 together with the sulfuric acid-hydrogen peroxide mixture, or are carried to the outside of the substrate 11 and discharged through the discharge port 44 together with the sulfuric acid-hydrogen peroxide mixture.

As described above, in the substrate processing device 10, the substrate 11 is heated by the light from the LEDs 37a of the light source unit 34, and thus the oxidative decomposition of the resist film by the sulfuric acid-hydrogen peroxide mixture is promoted. Moreover, since the processing surface S1 is heated by a uniform temperature, the oxidative decomposition of the resist film progresses uniformly.

In a configuration using an infrared lamp as in the related art, the substrate 11 has a high transmittance for most of the wavelength range of light output from the infrared lamp, and thus heating efficiency of the substrate 11 is low. For example, in the configuration in which the substrate 11 is held with the processing surface S1 facing upward and light is emitted from above, the sulfuric acid-hydrogen peroxide mixture on the processing surface S1 is directly irradiated with light and heated, and thus the sulfuric acid-hydrogen peroxide mixture that does not contribute to removing the resist film is heated, and the heating efficiency is low. In this regard, in the substrate processing device 10, the light from the LEDs 37a is directly emitted onto the back surface S2 and absorbed by the substrate 11, thereby heating the substrate 11. The sulfuric acid-hydrogen peroxide mixture in contact with the substrate 11 is then heated. Therefore, the sulfuric acid-hydrogen peroxide mixture that is in contact with the processing surface S1 and contributes to removing the resist film is efficiently heated.

The light from the LEDs 37a has a wavelength that is not transmitted through the substrate 11, and thus the light from the LEDs 37a does not pass through the substrate 11 to be emitted onto the rotating table 14 to heat the rotating table 14. Most of the light from the LEDs 37a contributes to heating the substrate 11, and thus the substrate 11 can be heated efficiently.

During the turning on of the LEDs 37a, that is, during the heating of the substrate 11, the light emission control unit 35 controls the LEDs 37a based on the measurement results of the radiation thermometers 37b. Therefore, for example, if the temperature of the substrate 11 measured by the radiation thermometer 37b disposed in the region D3 is higher than a target temperature, the light emission control unit 35 reduces the light emission intensity of the LEDs 37a arranged in the region D3. Accordingly, a temperature of a region of the substrate 11 corresponding to the region D3 is reduced. Conversely, if the temperature of the substrate 11 measured by the radiation thermometer 37b disposed in the region D3 is lower than the target temperature, the light emission control unit 35 increases the light emission intensity of the LEDs 37a arranged in the region D3, thereby increasing the temperature of the region of the substrate 11 corresponding to the region D3. In this way, the entire surface of the substrate 11 is kept at the target temperature uniformly.

The radiation thermometer 37b is configured to measure the temperature of the substrate 11 by using the light in the wavelength range that does not include the light from the LEDs 37a. Therefore, the temperature of the substrate 11 is accurately measured by the radiation thermometers 37b without being affected by the light from the LEDs 37a reflected by the substrate 11, an inner surface of the housing 12, the guide cylinder 41, and the like. Therefore, the temperature of the substrate 11 is controlled to the target temperature with higher precision. During the measurement of the temperature of the substrate 11 by the radiation thermometer 37b, there is no need to turn off the LEDs 37a, and the turning on can be continued to maintain a heating state, and thus the temperature of the substrate 11 does not drop temporarily. In other words, the radiation thermometer 37b can continuously measure the temperature of the substrate 11, and the light emission control unit 35 can continuously control the light emission intensity of the LEDs 37a based on the measured temperature. Accordingly, the substrate 11 can be precisely controlled to reach a target temperature.

After a predetermined processing time has elapsed since the start of the supply of the sulfuric acid-hydrogen peroxide mixture, the supply of the sulfuric acid-hydrogen peroxide mixture from the supply unit 26 is stopped. The predetermined processing time is preset as the time enough to completely remove the resist film. The LED 37a is turned off, and the light source unit 34 is moved to the retracted position.

After the light source unit 34 moves to the retracted position, the pure water is supplied from the supply unit 26 to the nozzle head 27b through the supply pipe 28c. Accordingly, the pure water is sprayed from the nozzle head 27b toward the processing surface S1 of the substrate 11, and the pure water flows toward the outer periphery of the substrate 11 while spreading in the circumferential direction on the processing surface S1 due to the rotation of the substrate 11. The pure water is supplied from the water pipe 47 to the back surface S2 of the substrate 11. Accordingly, the pure water flows toward the outer periphery of the substrate 11 while spreading in the circumferential direction on the back surface S2 due to the rotation of the substrate 11. In this way, the pure water is supplied to the entire processing surface S1 and the entire back surface S2, respectively, to perform cleaning. After a predetermined time has elapsed, the supply of the pure water to the nozzle head 27b and the water pipe 47 is stopped.

During the above processing performed with the pure water, the pure water is supplied to the upper surface of the rotating table 14 from a nozzle for table (not illustrated) provided in the nozzle unit 27. Accordingly, similar to the substrate 11, foreign matters such as particles adhering to the upper surface of the rotating table 14 are removed, and the upper surface of the rotating table 14 is cleaned with the pure water. The sulfuric acid-hydrogen peroxide mixture and the pure water splashed from the rotating substrate 11 and rotating table 14 collide with an inner wall of the housing 12. Therefore, the foreign matters such as particles adhering to the inner wall of the housing 12 are removed, and cleaning with the pure water is performed. In this way, in the substrate processing device 10, the substrate 11 is processed, and the interior of the housing 12 is simultaneously self-cleaned. Note that regarding the chuck pins 25a and the support pins, cleaning is performed by supplying the pure water from the dedicated nozzle to each of the predetermined number of processing pins.

After cleaning with the pure water, the rotation speed of the rotating table 14 is increased. Accordingly, the pure water adhering to both sides of the substrate 11 splashes due to centrifugal force, and the substrate 11 is drained. In this case, the rotating table 14 and substrate holding unit 25 are also drained.

When the resist film is removed, the cleaning is performed with the pure water, and the draining is performed as described above, the sulfuric acid-hydrogen peroxide mixture and the pure water that flow out from the substrate 11 or the rotating table 14, as well as the sulfuric acid-hydrogen peroxide mixture and the pure water that adhere to the inner wall of the housing 12 and flow down, are suctioned and discharged from the discharge port 44. Even if fine droplets or vapor of the sulfuric acid-hydrogen peroxide mixture and the pure water are generated, these droplets and vapor are guided to the discharge port 44 by the airflow from the upper opening 12a. Therefore, droplets or vapor of the sulfuric acid-hydrogen peroxide mixture and the pure water do not leak out from the upper opening 12a.

Once the draining is complete, the rotation of the rotating table 14 is stopped. The rotating table 14 moves from the lowered position to the raised position, and the holding of the substrate 11 due to the clamping by the chuck pins 25a is released. The substrate 11 is carried to another substrate processing device by the loading mechanism 15, is sequentially cleaned with an SC-1 processing solution and the pure water, and then dried. The substrate 11 is then returned to the storage cassette by the loading mechanism 15.

In this manner, processing on one substrate 11 is completed, and then a new substrate 11 is processed using the same procedure. Since self-cleaning of the rotating table 14 and the interior of the housing 12 is completed as described above, the processing on the new substrate 11 can be performed immediately.

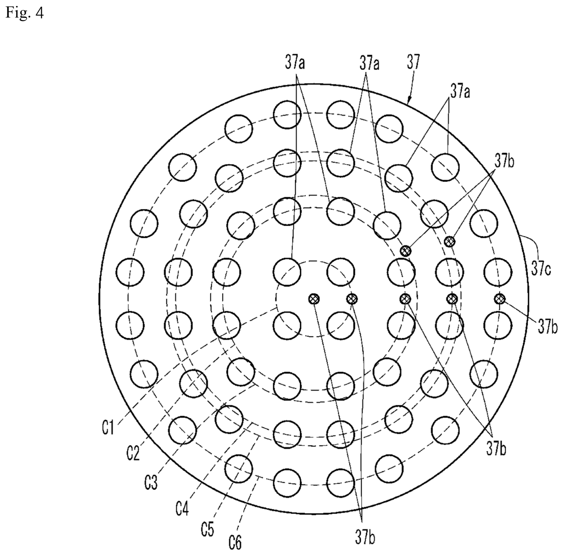

The arrangement of the LEDs 37a and the radiation thermometers 37b in the LED unit 37 and the method of controlling the LEDs 37a are merely examples and are not limited to those described above. In an example illustrated in Fig. 4, the plurality of LEDs 37a are arranged on concentric circles C1 to C6 of different diameters, with the center of the base plate 37c, which is the facing region, as the center of the concentric circles, and the radiation thermometers 37b are arranged on the center of the base plate 37c (facing region) and the concentric circles C1 to C6. In this example, the plurality of LEDs 37a on the same concentric circle are controlled based on the temperature measurement results for the substrate 11 of the radiation thermometer 37b on the same concentric circle. The LEDs 37a on the concentric circle C1 are controlled based on the temperature measurement results of the radiation thermometer 37b on the concentric circle C1 and the radiation thermometer 37b at the center of the base plate 37c. Note that the method of controlling the LEDs 37a is not limited to this.

The above example describes processing for removing a resist film using a sulfuric acid-hydrogen peroxide mixture as a fluid for processing, the processing using the fluid for processing is not limited thereto, and may be, for example, etching. The fluid for processing is not limited to the sulfuric acid-hydrogen peroxide mixture, and may use a fluid according to processing. For example, the present invention can be applied to processing for etching a silicon nitride (SiN) film on a substrate (silicon substrate) using a phosphoric acid solution containing phosphoric acid, such as a phosphoric acid aqueous solution, as the fluid for processing. In this case, the substrate is heated to, for example, approximately 160°C using light from an LED unit in the heating unit.

Furthermore, the fluid for processing may be either a liquid or a gas. For example, the present invention can also be applied to a case where a resist film is removed using ozone gas as the fluid for processing. Removal of the resist film using ozone gas is described, for example, in JP-A-2020-120010. The present invention can also be applied to a case where a two-phase gas-liquid fluid obtained by mixing ozone gas with ozone water is used as the fluid for processing to pass over a processing surface of a substrate to remove a resist film. Removal of the resist film using a two-phase gas-liquid fluid is described, for example, in JP-A-2020-120011.

In the above example, one guide cylinder is provided in the housing, but a plurality of guide cylinders with openings at upper portions at different heights may be provided in a manner of causing axes to coincide with the rotation center of the rotating table, and the rotating table may be raised and lowered to be rotatable in the opening formed at the upper portion of each of the guide cylinders. According to this configuration, a plurality of airflow paths are formed between the outermost guide cylinder and the housing, and between the guide cylinders. Accordingly, the height of the rotating table is changed depending on the type of gas or processing liquid to be supplied, thereby changing the flow paths through which the gas and process liquid flowing out between the rotating table and the substrate flow, and the gas and process liquid are separately discharged to the outside of the housing. Note that such a configuration is described in JP-A-2012-209559 and JP-A-2007-180268.

### Reference Sign List

- 10: substrate processing device
- 11: substrate
- 14: rotating table
- 16: process liquid supply unit
- 18: heating unit
- 35: light emission control unit
- 37a: LED
- 37b: radiation thermometer
- S1: processing surface
- S2: back surface

## Claims

1. A substrate processing device comprising:
a rotating table rotatably disposed around a vertical axis and configured to rotate during processing for a processing surface of a substrate;
a substrate holding unit provided on the rotating table and configured to hold the substrate horizontally with the processing surface facing downward and being away from an upper surface of the rotating table, and to rotate integrally with the rotating table;
a process liquid supply unit disposed between the substrate held on the rotating table and the rotating table, and configured to spray a fluid for processing to supply the fluid for processing to the processing surface; and
a heating unit disposed above the substrate held on the rotating table, including a plurality of light emitting diodes that emit light onto the substrate while the fluid for processing is being supplied to the processing surface, and configured to heat the substrate with the light from the plurality of light emitting diodes.

2. The substrate processing device according to claim 1, wherein
the plurality of light emitting diodes output light within a wavelength range that is not transmitted through the substrate.

3. The substrate processing device according to claim 1, wherein
the plurality of light emitting diodes output light of a single wavelength.

4. The substrate processing device according to claim 1, wherein
the plurality of light emitting diodes output light of a single wavelength having a peak wavelength within a wavelength range that is not transmitted through the substrate.

5. The substrate processing device according to claim 4, wherein
the substrate is a silicon substrate, and
the plurality of light emitting diodes output light having a peak wavelength of less than 1.1 µm.

6. The substrate processing device according to any one of claims 1 to 5, further comprising:
a temperature measurement unit including one or more radiation thermometers that measure a temperature of the substrate by detecting light of a wavelength different from the light output from the plurality of light emitting diodes; and
a light emission control unit that controls the output of the plurality of light emitting diodes based on a measurement result of the temperature measurement unit.
